# EUROPÄISCHE PATENTSCHRIFT

(11) **EP 4 213 659 B1**
(45) Veröffentlichungstag und Bekanntmachung des Hinweises auf die Patenterteilung: **11.09.2024**
(21) Anmeldenummer: 20781447.6
(22) Anmeldetag: 17.09.2020
(51) Int. Cl.: A24F 40/90, A24F 40/40, A24F 40/42, A24F 40/51, A24F 40/60, A24F 40/10

(54) **LADESPITZE FÜR EINE ELEKTRISCHE ZIGARETTE**
CHARGING TIP FOR AN ELECTRIC CIGARETTE
EMBOUT DE CHARGE POUR UNE CIGARETTE ÉLECTRIQUE

(43) Veröffentlichungstag der Anmeldung: 26.07.2023
(73) Patentinhaber: CARNAULT AG, 4057 Basel (CH)
(72) Erfinder: KAISER, Benjamin, 4057 Basel (CH); KAISER, Tobias, 4056 Basel (CH); BAUER, Stefan, 83064 Raubling (DE); BOCK, Daniel, 09111 Chemnitz (DE); SCHWITZER, Michael, 09244 Lichtenau (DE)
(74) Vertreter: Schirbach, Marcel
(86) Internationale Anmeldenummer: PCT/EP2020/076045
(87) Internationale Veröffentlichungsnummer: WO 2021/254649

(56) Entgegenhaltungen:
- EP-A1- 3 240 442
- EP-A2- 3 369 328
- DE-A1- 102019 124 541
- DE-U1- 202014 004 361
- US-A- 6 070 592
- US-A1- 2017 000 190

## Beschreibung

### Gebiet der Erfindung

Die vorliegende Erfindung fällt in das Gebiet des täglichen Lebensbedarfs und betrifft eine Ladespitze für eine elektrische Zigarette gemäss dem Oberbegriff des Anspruchs 1.

### Stand der Technik, technologischer Hintergrund der Erfindung

Herkömmliche elektrische Zigaretten sind handliche Geräte, welche unter Einsatz von elektrischer Energie aus einer Vorläuferzusammensetzung ein inhalierbares Aerosol erzeugen. Zu diesem Zweck verfügt jede elektrische Zigarette mindestens über die nachfolgenden Funktionselemente: eine Energiequelle, elektronische Steuerkomponenten, eine Vorläuferzusammensetzung und eine Aerosolisierungseinheit. Letztere kann aus einem Heizelement, z.B. einem Glühdraht oder einem Heizchip, oder einer anderweitigen Baugruppe bestehen, welche in der Lage ist, die Vorläuferzusammensetzung in ein Aerosol zu überführen, z.B. mithilfe eines Ultraschall-Zerstäubers, oder mittels einer Ein- oder Zweistoffzerstäuberdüse. Die Vorläuferzusammensetzung kann dabei einerseits aus einem Liquid bestehen oder andererseits Festbestandteile beinhalten, wie z. B. präparierte Tabakerzeugnisse (sogenannte Heat-not-Burn-Produkte).

Elektrische Zigaretten sind darauf ausgelegt, gleich traditionellen Tabakzigaretten verwendet zu werden. Ein Nutzungsszenario, wie es beim Konsum einer traditionellen Tabakzigarette die Regel ist und folglich bei elektrischen Zigaretten im Bereich des Erwartbaren liegt, bestünde darin, dass mehrmals hintereinander mit kurzen Pausen zwischen den einzelnen Zügen das durch die elektrische Zigarette erzeugte Aerosol inhaliert wird. Ein solcher Vorgang, wobei die elektrische Zigarette üblicherweise in der Hand gehalten, an den Mund geführt und schließlich das Aerosol in Form einer Art Nebel oder Dampf ein- und in Teilen wieder ausgeatmet wird, ist auch durch eine erwünschte Sicht- und Wahrnehmbarkeit gegenüber Außenstehenden beeinflusst. Das Rauchen traditioneller Tabakzigaretten wurde und wird in vielen Teilen der Welt massiv beworben. Dabei wurde und wird mitunter versucht, es mit positiven Werten, wie Geselligkeit, Authentizität und Freiheit in Verbindung zu bringen. Der globale Erfolg traditioneller Tabakzigaretten, welcher sich in der hohen Zahl an Konsumenten von mehr als einer Milliarde Menschen ausdrückt, könnte ein Zeichen dafür sein, dass dieser Versuch mindestens teilweise geglückt ist. So legt auch die Tatsache, dass das Rauchen von Tabakzigaretten extrem weit verbreitet ist, nicht jedoch die Verwendung von ähnlich wirkenden, oft günstigeren und in einigen Fällen weitaus weniger schädlichen nikotinhaltigen Produkten, wie z.B. Oraltabak, nahe, dass gerade die hohe Sicht- und Wahrnehmbarkeit des Rauchvorgangs und des Produkts einen maßgeblichen Einfluss auf dessen Erfolg hat beziehungsweise dessen Fähigkeit, mit positiven Werten verknüpft zu werden.

Diese Erwägungen lassen den Schluss zu, dass der Erfolg einer elektrischen Zigarette ebenfalls in hohem Maße von der Außenwahrnehmung des Produkts selbst und von der Außenwahrnehmung während der Verwendung des Produkts abhängig ist. Im gleichen Sinne liegt auch der Schluss nahe, dass das Design für die Frage mitentscheidend ist, inwiefern sich eine elektrische Zigarette mit eben jenen Werten glaubhaft verbinden lässt, welche der Tabakzigarette zu besagtem Erfolg verholfen haben. Dabei sei festzuhalten, dass diese bereits oben beschriebenen Werte mindestens insofern als zeitlos zu bezeichnen sind, da es sich für Menschen um fundamentale, in beinahe jeder Kultur ausgiebig und intensiv thematisierte Werte handelt, bei denen davon ausgegangen werden kann, dass sie auch in der Zukunft relevant sein werden. Das Produktdesign ist damit ein wesentliches Differenzierungsmerkmal sowohl gegenüber anderen elektrischen Zigaretten als auch gegenüber traditionellen Tabakzigaretten und kann unter Umständen das einzige Unterscheidungskriterium sein, welches nach außen hin sichtbar ist. Es kann folglich von erfolgsentscheidendem Vorteil sein, wenn sich eine elektrische Zigarette durch einen oder mehrere der folgenden Aspekte auszeichnet, namentlich eine hochwertige Materialwahl der nach außen hin sichtbaren Baugruppen, eine hohe Verarbeitungsqualität, eine hohe Lebensdauer, Möglichkeiten der Individualisierung des Außen-Designs, etwa durch eine Austauschbarkeit von Baugruppen, eine geringe Produktgröße, die einer angenehmen Handlichkeit bzw. Haptik und einer einfachen Handhabung entgegenkommt, und Dimensionen, welche der Form und Größe einer klassischen Tabakzigarette so nahe wie möglich kommen, da man davon ausgehen kann, dass viele Menschen an die Form und Größe klassischer Tabakzigaretten gewöhnt sind und zudem an deren Gewicht. Ferner sind heute Aspekte wie Umweltfreundlichkeit, Abfallminimierung, Recyclingfähigkeit und die Abfalltrennung von Materialien von Bedeutung. Selbiges gilt hinsichtlich der Materialwahl. Ausgewählte Materialien, wie z. B. Holz oder Ebonit sind Rauchern aus zigarettenverwandten Produkten wie Tabakpfeifen wohl bekannt, wodurch der Rückgriff auf solche Materialien bei elektrischen Zigaretten gleichfalls eine Vertrautheit bei Rauchern hervorzurufen vermögen könnte.

Ferner soll in der elektrischen Zigarette eine Steuerelektronik ein zuverlässiges und sicheres Funktionieren der Aerosolerzeugung gewährleisten und gegebenenfalls erweiterte Funktionen umfassen, wie beispielsweise die Möglichkeit einer Bluetooth-Anbindung an ein Smartphone oder einer Authentifizierung des Verbrauchsguts in einer sogenannten Cartridge bzw. Patrone und ferner eine Mengenkontrolle; dabei geht der erweiterte Funktionsumfang unmittelbar mit einem erhöhten Platzbedarf für elektronische Komponenten bzw. für elektronische Bauelemente einher, z.B. für komplexere Schaltungsstrukturen in und um integrierten Schaltkreisen [IC - integrated circuits]. Zudem umfasst eine solche Steuerelektronik ein Einschaltelement in Form eines Schalters, Tasters oder Sensors, welcher einen Luftzug des Kunden zu registrieren vermag (z. B. Drucksensor, Luftflusssensor, Temperatursensor), sowie gegebenenfalls Anzeigeelemente, wie z. B. eine LED, und Komponenten zur Auswertung. Des Weiteren ist die Modularität von elektrischen Zigaretten zwecks Austausches einzelner Komponenten im Fall von Weiterentwicklungen und Verbesserungen oder im Schadensfall von Vorteil. Hierzu sind diverse Schnittstellen und Kontakte erforderlich, welche einen zusätzlichen Platzbedarf erforderlich machen können.

Bei einer Akkuzelle ist als Energiequelle eine hohe abrufbare Stromstärke und eine möglichst hohe nutzbare Kapazität vorteilhaft, wobei damit die positive Korrelation zwischen Akkukapazität und maximalem Entladestrom einhergeht, sowie der meist unvorteilhaften positiven Korrelation zwischen Kapazität, maximalem Entladestrom und einem entsprechend grossen Volumen bzw. einer entsprechend grossen Masse einer solchen Akkuzelle.

Selbstverständlich bleiben mit Blick auf geringe Produktionskosten wirtschaftliche Aspekte nicht ausser Acht, die auf eine entsprechend einfache Montage, günstige Komponenten oder einen hohen Grad an Automatisierung abstellen.

Einige der oben genannten Anforderungen an elektrische Zigaretten stehen zueinander in einem Zielkonflikt und bedürfen somit ein Abwägen zwischen unbedingt zu erfüllenden Vorteilen und damit andererseits einhergehenden zweitrangigen Nachteilen.

So führt beispielsweise die Verwendung natürlicher Materialien wie z. B. Holz oder Ebonit dazu, dass eine gewisse der Stabilität geschuldete Mindestwandstärke nicht unterschritten werden kann, die grösser ausfällt als etwa bei Edelstahl oder anderweitigen Metallen und Legierungen, so dass z. B. Hülsen aus Holz oder Ebonit mit einem erhöhten Platzbedarf einhergehen. Um der Form und Grösse einer Tabakzigarette möglichst treu bleiben zu können und gleichsam eine technisch fortschrittliche elektrische Zigarette realisieren zu können, macht dies eine platzsparende Konstruktion unumgänglich.

Des Weiteren hat zum Beispiel eine kreiszylindrische Gehäuse-Form zur Folge, dass die Batteriezelle, um optimal in diese Form hineinpassen zu können, ebenfalls kreiszylindrisch sein muss. Allerdings gilt zumindest für kleine Zellgrössen, dass sich bei gleichem Volumen quaderförmige Akkuzellen mit einer höheren Kapazität realisieren lassen als kreiszylindrische Akkuzellen. Dies liegt im grundsätzlichen Lagenaufbau von Akkuzellen begründet. Bei einer runden Zelle werden die Elektroden- und Separator-Lagen zumeist aufgerollt, wodurch aufgrund des beschränkten Krümmungswinkels der verwendeten Lagen mittig ein ungenutzter Hohlraum entsteht. Umso wichtiger ist eine effiziente Bauraumnutzung in einem kreiszylindrischen Gehäuse. Ein quaderförmiger Gehäuseaufbau kommt zusätzlich auch der Bauweise von Leiterplatten entgegen. Eine flache und rechteckige Leiterplatten-Form lässt sich ohne Einbussen in Sachen Baugrösse oder Funktionalität leichter realisieren und kann zur gleichen Zeit platzeffizient in ein quaderförmiges Gehäuse integriert werden. Die elektronischen Komponenten, mit welchen die Leiterplatte einer Kontrolleinheit bestückt wird, sind oftmals selbst rechteckig, entsprechend lassen sie sich auf einer rechteckigen Leiterplatten-Fläche effizienter anordnen als auf einer runden. Ein quaderförmiges Gehäuse kommt somit der Bauform von Akkuzellen und Leiterplatten eher entgegen als es bei einem kreiszylindrischen der Fall wäre und würde beispielsweise den Zielkonflikt kleine Produktgrösse, möglichst leistungsfähige Akkuzelle und gute Platzausnutzung der Leiterplatte vereinfachen. In der Folge entfernt man sich aber von dem Ziel der Ähnlichkeit zur Tabakzigarette.

Unter den Aspekten der Nachhaltigkeit und Wirtschaftlichkeit macht ein Einsatz hochwertiger Materialien oder das Investieren in eine hohe Verarbeitungsqualität nur dann Sinn, wenn die entsprechenden Bauteile eine gewisse Haltbarkeit aufweisen. Folglich wäre es von Nachteil, wenn die Lebensdauer einer Batteriehülse, welche im zusammengebauten Zustand der elektrischen Zigarette den größten Teil der sichtbaren Fläche einnimmt und ein zentrales Design-Objekt darstellt, an die vergleichsweise begrenzte Lebensdauer der darin angeordneten Akkuzelle geknüpft wäre, wenn beide Teile fix miteinander verbunden wären. Um eine hohe Verarbeitungsqualität und einen Einsatz hochwertiger Materialien im Besonderen im Bereich der Batteriehülse auf sinnvolle Weise nachhaltig und wirtschaftlich anwendbar machen zu können, ist ein modular trennbarer Aufbau der Steuerelektronik bzw. Kontrolleinheit, der Batteriezelle und der Batteriehülse eine Voraussetzung. Ein hoher Grad an Modularität steht hier regelmässig im Widerspruch zu einer geringen Produktgröße, da die einzelnen Teile über trennbare mechanische und elektrische Verbindungen verfügen müssen, welche generell zusätzlichen Platz einnehmen. Außerdem, da höhere Anforderungen an die Konstruktion gestellt werden, kann diese komplexer werden: es kann sein, dass mehr und/oder komplexere Bauteile benötigt werden oder es eine größere Zahl an Arbeitsschritten für die Fertigung braucht, was negative Auswirkungen auf die Endmontage und die Produktionskosten hätte.

Möglichst leistungsstarke Akkuzellen stehen einer möglichst hohen Funktionalität der Steuerelektronik und einer geringen Produktgröße entgegen. Eine einfache Montage der elektrischen Zigarette kann im Widerspruch zu einer immer komplexer werdenden Steuerelektronik stehen, welche zuweilen den Einsatz flexibler Leiterplatten oder diverser Verkabelungen und zusätzlicher Teile zum Verbinden der Leiterplatte mit dem Gehäuse, zum Beispiel Spritzgussteile etc. zur Folge hat.

Eine einfache technische Bedienung kann ebenfalls negative Auswirkungen auf den Platzbedarf und die Produktgröße haben, dabei ist zudem erstrebenswert, dass die elektrische Zigarette während der Aufladung des Akkus in einem zusammengebauten und quasi funktionsfähigen Zustand verbleibt. Eine solche Ladbarkeit nimmt dabei möglicherweise zusätzlichen Raum ein im Gegensatz zu einem permanenten Verschluss, der keine weiteren Funktionen abbildet, etwa weil zusätzliche Verkabelungen erforderlich werden können. Ebenso können gesteigerte Anforderungen an die Funktionalität oder an die elektrische Konstruktion zu einem erhöhten Platzbedarf führen. Die Erkennung von Änderungen des Luftdruckes oder Luftdurchsatzes beim Rauchvorgang, so dass die elektrische Zigarette gleich einer Tabakzigarette benutzt werden kann, macht beispielsweise ein Luftflussmanagement erforderlich. Oftmals wird dabei auf zusätzliche Bauteile nebst einem Drucksensor zurückgegriffen.

Aus der Druckschrift US 2014 014 124 A1 ist eine elektrische Zigarette gemäss dem Stand der Technik bekannt, welche Zigarette einen Zigarettenkörper mit einer Hülle und einem Mundstück umfasst, wobei diese Hülle einen vorderen Teil hat, der in dem Mundstück endet. Der Zigarettenkörper umfasst als eine Kontrolleinheit eine Batterie und einen Ladeschaltkreis, der betriebsmässig mit der Batterie gekoppelt ist. Ein zentraler Ladekontakt und ein ringförmiger Ladekontakt sind an einer Ladespitze der elektrischen Zigarette angeordnet und operativ mit dem Ladeschaltkreis gekoppelt. Dieser konventionelle Aufbau der elektrischen Zigarette umfasst dementsprechend Bauelemente, die als sogenannte diskrete Bauelemente ausgeführt sind und durch Leitungen miteinander verbunden sind und somit ein entsprechend grosses Bauvolumen beanspruchen.

Die Druckschrift DE202014004361U1 offenbart ein Akkumodul für eine Rauchvorrichtung mit einem Gehäuse, einer in dem Gehäuse angeordneten ladbaren Stromquelle zum Betreiben der Rauchvorrichtung und einer Ladepolanordnung zum Laden der Stromquelle mit mindestens zwei Ladepolen, dadurch gekennzeichnet, dass das Akkumodul eine Verpolschutzschaltung aufweist, welche auf eine Eingangsgleichspannung an den Ladepolen eine Ausgangsgleichspannung einer vorgegebenen Polarität zum Laden der Stromquelle bereitstellt.

In der Druckschrift EP3369328A2 wird ein Ladesystem für elektronische Zigaretten offenbart, umfassend eine elektronische Zigarette mit einem ersten Satz elektrischer Kontakte, einem Zerstäuber und einer wiederaufladbaren Batterie zum Betreiben des Zerstäubers. Das System umfasst ferner eine Elektrodenbaugruppe, die mit einer Stromquelle verbunden werden kann und einen zweiten Satz elektrischer Kontakte aufweist, die so angeordnet sind, dass sie mit dem ersten Satz elektrischer Kontakte zusammenpassen, woraufhin die elektronische Zigarette über die Elektrodenbaugruppe Strom erhält, um die Batterie wieder aufzuladen, während sie für die Verwendung durch einen Raucher betriebsbereit bleibt. Elektrische Schaltkreise, die mit dem ersten Satz elektrischer Kontakte verbunden sind, umfassen einen ersten Schaltkreis zur Versorgung des Zerstäubers mit Batteriestrom und einen zweiten Schaltkreis zur Versorgung der Batterie mit Strom von einem Batterieladegerät zum Aufladen der Batterie, wobei der erste Schaltkreis mit dem zweiten Schaltkreis zusammenwirkt, um den Stromfluss über die Elektrodenanordnung zur Batterie zu unterbrechen, wenn der Zerstäuber aktiviert ist, und um den Stromfluss wieder aufzunehmen, wenn der Zerstäuber nicht mehr aktiviert ist.

In der Druckschrift EP3240442A1 ist eine Vorrichtung zum Erhitzen von rauchbarem Material beschrieben, um mindestens eine Komponente des rauchbaren Materials zu verflüchtigen. Die Vorrichtung umfasst eine elektrische Stromquelle mit einem positiven und einem negativen Anschluss, einen Spannungsregler und ein Steuergerät zum Steuern der Zufuhr von elektrischem Strom zu einem Heizelement im Gebrauch. Einer der Plus- und Minuspole ist über den Spannungsregler elektrisch mit dem Steuergerät verbunden. Der andere der positiven und negativen Anschlüsse ist über einen elektrisch leitenden Pfad, der den Spannungsregler umgeht, elektrisch mit dem Steuergerät verbunden.

Die Druckschrift US2017000190A1 offenbart eine elektronische Zigarettenvorrichtung, die ein äußeres Rohr, eine Heiz-Zerstäubungskomponente, die in dem äußeren Rohr untergebracht ist, eine PCB-Komponente, die an einem Boden der Heiz-Zerstäubungskomponente angeordnet ist, und eine Batterie umfasst, die elektrisch mit der PCB-Komponente verbunden ist. Die heizende Zerstäubungskomponente umfasst ein Heizelement, ein Verbindungsstück, das elektrisch mit der Unterseite des Heizelements verbunden ist, und ein Zerstäubungsrohr, das ummantelt außerhalb des Heizelements und des Verbindungsstücks angebracht ist. Das obere Ende des Zerstäubungsrohrs ist mit einem Flüssigkeitseinfülldeckel und einem abnehmbaren Inhalationsschnabel versehen und angeordnet. An der Unterseite des Verbinders befindet sich eine Leiterplatte. Ein Elektrodenkontakt, der zur elektrischen Verbindung mit der Leiterplatte verwendet wird, ist an der Oberseite der PCB-Komponente angeordnet. Eine Vielzahl von Mikro-Lufteinlasslöchern ist auf der gedruckten Leiterplatte installiert und angeordnet.

### Darstellung der Erfindung

Es ist deshalb Aufgabe der vorliegenden Erfindung, eine Ladespitze für eine elektrische Zigarette dahingehend weiterzuentwickeln, dass das in der elektrischen Zigarette zur Verfügung stehende Volumen möglichst effizient genutzt wird, das heisst, dass beispielsweise ein Ladeschaltkreis mit zugehörigen elektrischen Verbindungen zur Ladespitze und/oder zur Batterie möglichst effizient hinsichtlich eines minimal notwendigen Bauvolumens ausgeführt wird und zudem gegenüber dem Stand der Technik vereinfacht ausgeführt wird.

Die der Erfindung für die Ladespitze einer elektrischen Zigarette zugrundeliegende Aufgabe wird gelöst durch die Merkmale im kennzeichnenden Teil des Anspruchs 1; die diesen Erfindungsgedanken weiterbildenden Merkmale sind jeweils Gegenstand der Unteransprüche 2 bis 10.

Die erfindungsgemässe Ladespitze für eine elektrische Zigarette weist somit eine Anzahl elektrischer Kontaktflächen auf die zwecks einer Aufladung der elektrischen Zigarette und/oder zwecks eines Datenaustauschs mit der elektrischen Zigarette kontaktierbar sind, wobei diese Ladespitze zudem einen Steuerelementkörper mit einem Körperdurchmesser senkrecht zu der zentralen Z-Achse der elektrischen Zigarette umfasst, welcher Steuerelementkörper mit der elektrischen Zigarette einen Passsitz ausbildet. Gegenüber dem Stand der Technik hebt sich die erfindungsgemässe Ladespitze insbesondere durch ihre kompakte Baustruktur ab, die auf kleinstem Raum im und am Steuerelementkörper elektrische Kontakte nach aussen aber auch nach innen zur elektrischen Zigarette kontaktierbar umfasst. Auf diese Weise ergibt sich für die Ladespitze gemäss der Erfindung eine gegenüber dem Stand der Technik wesentlich verbesserte Raumnutzung und zudem ein höherer Modularitätsgrad, denn der mittels des Passsitzes angeordnete Steuerelementkörper ist bei Bedarf oder auf Wunsch zerstörungsfrei austauschbar.

Vorteilhaft ist, wenn der Steuerelementkörper lösbar in einem Verschlusselement oder in einer Batteriehülse an der Ladespitze der elektrischen Zigarette den Passsitz ausbildet und mit dem Verschlusselement bzw. der Batteriehülse elektrisch wirkverbunden ist. Eine weitere Ausführungsform sieht vor, dass der Steuerelementkörper lösbar an der Ladespitze der elektrischen Zigarette mittels des Passsitzes positionierbar und mit einem Pressring fixierbar ist.

Eine vorteilhafte Ausführungsform sieht vor, dass die Anzahl elektrischer Kontakte zur Kontrolleinheit nach aussen an der Ladespitze als Flächenkontakte bzw. Kontaktflächen ausgebildet sind. Besonders vorteilhaft wäre hierbei, diese Flächenkontakte bzw. Kontaktflächen als Kreisflächen oder Ringflächen auszubilden. Die Anzahl elektrischer Kontakte dient typischerweise der Energiespeisung von aussen zwecks Ladung der Batterie der elektrischen Zigarette bzw. einer Datenkommunikation.

Bei einer weiteren Ausführungsform der Erfindung ist vorteilhaft, wenn die mindestens eine Leiterplatte mindestens einen Sensor und/oder mindestens einen Mikrocontroller und/oder mindestens ein elektronisches Bauelement aufweist, welche elektrisch auf dieser mindestens einen Leiterplatte und/oder mittels einer Leiterbahn und/oder mittels einer Durchkontaktierung mit der Anzahl elektrischer Kontakte, oder mit einem Mantelflächenkontakt in elektrischer Wirkverbindung stehen. Dabei ist ferner vorteilhaft, wenn der mindestens eine Sensor und/oder der mindestens eine Mikrocontroller und/oder das mindestens eine elektronische Bauelement mit der mindestens einen Leiterplatte als in die Leiterplattenstruktur eingebettete, integrierte elektronische Komponenten ausgebildet sind. Weitere vorteilhaft Ausführungsformen der Erfindung sind beispielsweise in der Verwendung einer Authentifizierungsvorrichtung in der Leiterplattenstruktur zu sehen, oder im Einsatz eines Schaltelement. Auf diese Weise ergibt sich im Steuerelementkörper der Ladespitze die höchste Dichte an integrierbaren Funktionselementen und somit die effizienteste Raumausnutzung. Beim Einsatz mehrerer, in Z-Richtung voneinander beabstandeter Leitplattenebenen sind zusätzliche Durchkontaktierungen für die Herstellung von weiteren elektronischen Verbindungen vorteilhaft.

Für den Passsitz des Steuerelementkörpers der Ladespitze eignen sich besonders gut ein Passsitz mit einer sogenannten Spielpassung oder ein Passsitz mit einer sogenannten Übergangspassung, wobei im ersten Fall der Steuerelementkörper gerade noch leicht verschiebbar in der Ladespitze angeordnet ist und im letzteren Fall der Steuerelementkörper mit geringem Druck verschiebbar in der Ladespitze angeordnet ist. Bei der Ausführungsform mit der Spielpassung, kann ein Pressring vorgesehen sein, der den Steuerelementkörper im Innern der elektrischen Zigarette positioniert bzw. fixiert.

Bei der vorteilhaften Ausführungsform des Steuerelementkörpers mit einem runden Querschnitt, wobei die Z-Achse der elektrischen Zigarette mit der Zentralachse dieses Steuerelementkörpers zusammenfällt, erscheint diese dann topfartig, knopfbatterieartig oder tablettenförmig, so dass dieser Steuerelementkörper - sofern er mit einer Leiterplattenstruktur versehen ist- auch als Leiterplattentablette bezeichnet werden kann.

Weitere vorteilhafte Ausführungsformen werden anhand der nachfolgenden Figuren im Zusammenhang mit der detaillierten Erfindungsbeschreibung hervorgehoben.

### Kurze Beschreibung der Figuren

Im Folgenden wird die Erfindung anhand von Figuren beispielhaft erläutert. Gleiche Gegenstände sind in den Figuren grundsätzlich mit gleichen Bezugszeichen versehen. An dieser Stelle wird darauf hingewiesen, dass die Figuren keinerlei einschränkende Wirkung auf den Erfindungsgegenstand haben, sondern lediglich mögliche Ausführungsformen des Erfindungsgedankens darstellen.

### Es zeigen rein schematisch die

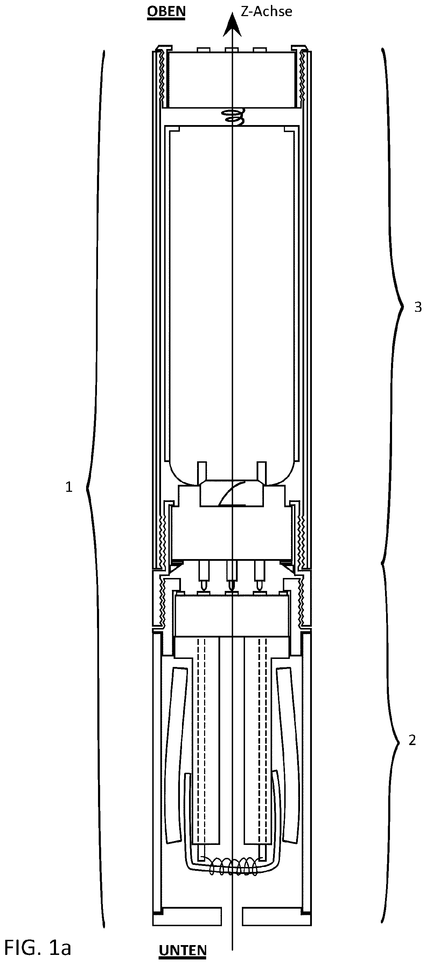

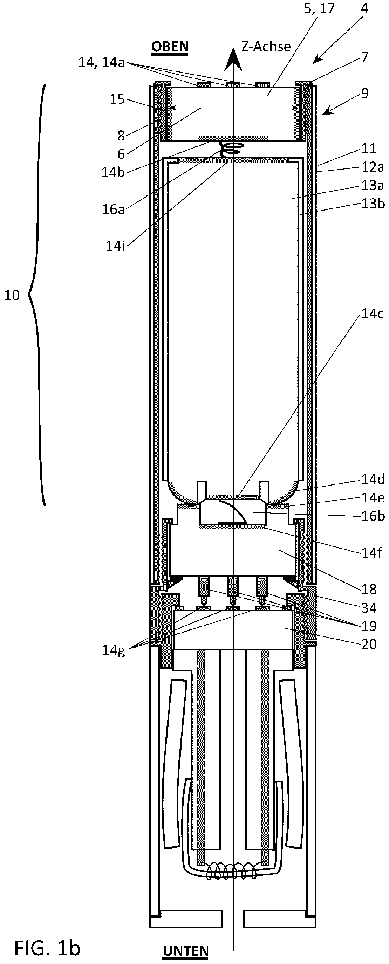

Fig. 1a, 1b eine Längsschnittdarstellung einer elektrischen Zigarette mit einer zentralen Z-Achse zwecks einer einfachen Beschreibung bei der Verortung einzelner Elemente der Zigarette mittels der hier auch teilweise in den Figuren verwendeten Begriffe, «oben», «unten», «nach oben hin», «nach unten hin», «oberer Abschluss», «unterer Abschluss», «Oberseite», «Unterseite», usw.; vorliegend weist diese elektrische Zigarette eine erfindungsgemässe Ladespitze mit einem Steuerelementkörper auf, der mittels Passsitz angeordnet ist; zudem sind die elektrischen Verbindungen dieser Ausführungsform der elektrischen Zigarette hervorgehoben dargestellt;
Fig. 2a, 2b eine weitere Längsschnittdarstellung der elektrischen Zigarette gemäss Fig. 1a, 1b mit einem Steuerelementkörper, der mittels des Passsitzes positioniert ist und mittels eines Pressrings fixiert ist; zudem sind die elektrischen Verbindungen dieser Ausführungsform der elektrischen Zigarette hervorgehoben dargestellt;
Fig. 3a, 3b eine weitere Längsschnittdarstellung der elektrischen Zigarette gemäss Fig. 1a, 1b mit einem geänderten, inneren Aufbau; zudem sind die elektrischen Verbindungen dieser Ausführungsform der elektrischen Zigarette hervorgehoben dargestellt;
Fig. 4a, 4b eine weitere Längsschnittdarstellung der elektrischen Zigarette gemäss Fig. 1a, 1b mit einer erweiterten elektrischen Verbindungsstruktur der Ladespitze; zudem sind die elektrischen Verbindungen dieser Ausführungsform der elektrischen Zigarette hervorgehoben dargestellt;
Fig. 5 perspektivische Darstellung der erfindungsgemässen Ladespitze in einer Verbindungsstruktur;
Fig. 6a, 6b eine weitere perspektivische Darstellung der Ladespitze gemäss Fig. 5 mit einer Anzahl Bohrungen bzw. einer Ausnehmung;
Fig. 7 eine weitere perspektivische Darstellung der Ladespitze mit einem Mantelflächenkontakt am Steuerelementkörper;
Fig. 8 eine weitere perspektivische Darstellung der Ladespitze gemäss Fig. 2a, 2b mit dem Pressring;
Fig. 9a, 9b, 9c eine weitere perspektivische Darstellung der Ladespitze gemäss Fig. 3a, 3b;
Fig. 10 eine Leiterplattenstruktur des Steuerelementkörpers in der Ladespitze;
Fig. 11 in einer weiteren perspektivische Darstellung die elektrische Zigarette mit der erfindungsgemässen Ladespitze.

### Wege zur Ausführung der Erfindung

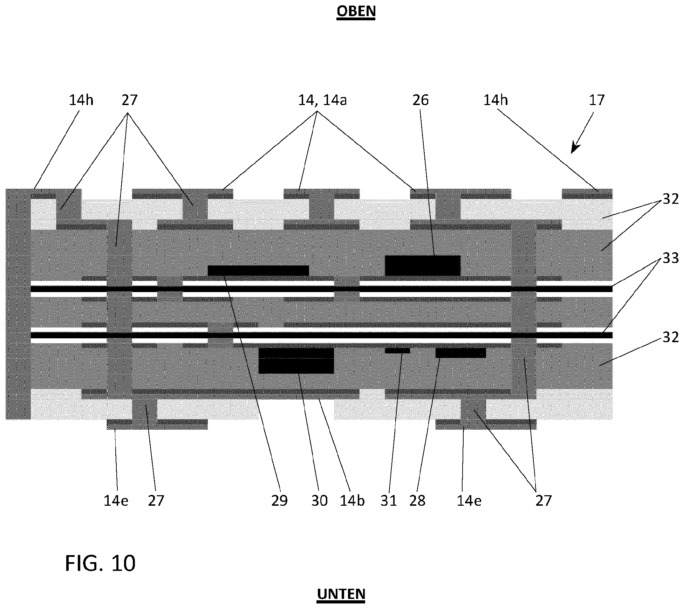

Die Figuren 1a und 1b zeigen eine Längsschnittdarstellung einer elektrischen Zigarette 1 mit einer zentralen Z-Achse mit einer Pfeilspitze am oberen Ende zwecks einer einfachen Beschreibung bei der Verortung einzelner Bestandteile der elektrischen Zigarette 1 mittels der hier auch teilweise in den Figuren verwendeten Begriffe, «oben», «unten», «nach oben hin», «nach unten hin», «oberer Abschluss», «unterer Abschluss», «Oberseite», «Unterseite», usw. Vorliegend umfasst die elektrische Zigarette 1 von unten nach oben eine Patroneneinheit 2 und eine daran lösbar angeordnete Kontrolleinheit 3, wobei an einem der Patroneneinheit 2 abgewandten Ende der elektrischen Zigarette 1 die erfindungsgemässe Ladespitze 4 angeordnet ist. Diese Ladespitze 4 weist eine Anzahl elektrischer Kontaktflächen 14, 14a auf, die zwecks einer Aufladung der elektrischen Zigarette 1 und/oder zwecks eines Datenaustauschs der elektrischen Zigarette 1 kontaktierbar sind. Erfindungsgemäss umfasst die Ladespitze 4 einen Steuerelementkörper 5 mit einem Körperdurchmesser 6 senkrecht zur zentralen Z-Achse, wobei dieser Körperdurchmesser 6 derart gewählt ist, dass der Steuerelementkörper 5 mit der elektrischen Zigarette 1 einen Passsitz ausbildet. Mit dieser Art der Ausgestaltung wird insbesondere mit Blick auf den Körperdurchmesser 6 die grösstmögliche Raumausnutzung des Steuerelementkörpers 5 ermöglicht, der zudem nach oben bzw. nach unten die elektrischen Kontaktflächen 14,14a, 14b ausgestattet ist und zudem einen Mantelflächenkontakt 15 aufweist. Der Steuerelementkörper 5 ist vorliegend als eine Leiterplattenstruktur 17 ausgebildet, auf die nachfolgend und insbesondere unter Zuhilfenahme der Fig. 10 gebührend einzugehen sein wird.

Wie in der Fig. 1b gezeigt, ist hier die Ladespitze 4 einer Batterieeinheit 10 zugeordnet, die in einer Batteriehülse 9 eine Batterie 13a mit einer umgebenden Batterieisolierung 13b aufweist, welche Batterie 13a nach oben zum Steuerelementkörper 5 bzw. zu dessen unteren elektrischen Kontaktfläche 14b eine elektrische Kontaktfläche 14i aufweist, wobei zwischen diesen beiden elektrischen Kontaktflächen 14b, 14i ein verbindender Federkontakt 16a angeordnet ist. In der vorliegenden Ausführungsform der Erfindung ist die Ladespitze 4 mit Passsitz in einem Verschlusselement 7 angeordnet, welches mittels einer Verbindungsstruktur 8 die elektrische Zigarette 1 nach oben hin verschliesst. Als Verbindungsstruktur 8 sind ein Gewinde ebenso denkbar wie ein Bajonettverschluss oder Rastelemente, wobei aber auch Klebetechniken unter der Vorgabe der Wiederlösbarkeit zum Einsatz gelangen können, da in jedem Fall ein modularer Aufbau der elektrischen Zigarette 1, bestehend aus gegebenenfalls austauschbaren Komponenten, angestrebt wird.

Der Steuerelementkörper 5 ist über den Mantelflächenkontakt 15 leitend mit dem Verschlusselement 7 verbunden und in der Folge über die Verbindungsstruktur 8 mit einer leitfähigen Innenröhre 12a der Batteriehülse 9. Diese leitfähige Innenröhre 12a ist nach aussen hin mit einer isolierenden Aussenröhre 11 umgeben. Am unteren Ende ist die leitfähige Innenröhre 11 mit einem Verschlussbauteil 34 und eine darin angeordnete Steuereinheit 18 verschlossen, welche nach oben Kontaktflächen 14f bzw. 14e aufweist, die mit unteren Kontaktflächen 14c, 14d der Batterie 13a in Verbindung stehen, wobei ein Federkontakt 16b die Kontaktflächen 14c und 14f brückt. Die Steuereinheit 18 ist am unteren Ende mit einer Anzahl Kontaktstiften 19 ausgestattet, die mit Kontaktflächen 14g einer Patroneneinheit elektrisch wirkverbunden sind. Von besonderem Vorteil ist, dass mittels der Kontaktflächen 14, 14a, 14b bzw. dem Mantelflächenkontakt 15 des Steuerelementkörpers 5 an der Ladespitze 4 elektrische Wortverbindungen über die leitfähige Innerröhre 12a der Batteriehülse 9 bis zur Steuereinheit 18 bzw. zur Patronensteuerung 20 bestehen und somit beispielsweise die Ladung der Batterie 13a aufgelöst bzw. vorgenommen werden kann oder ein Datenaustausch von und zu dem Steuerelementkörper 5, der Steuereinheit 18 bzw. der Patronensteuerung 20 erfolgen kann. Ein solcher Datenaustausch kann dabei zum Beispiel Schaltbefehle mitumfassen, sowie Parametrierdaten oder Programmierdaten.

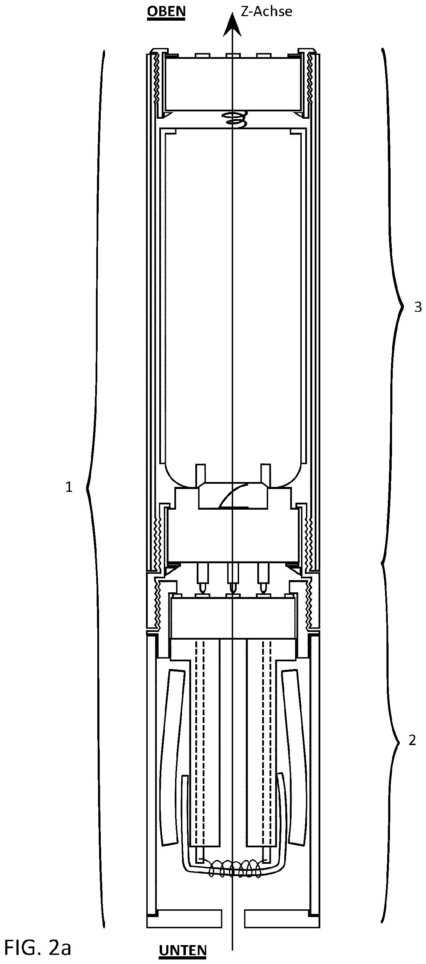

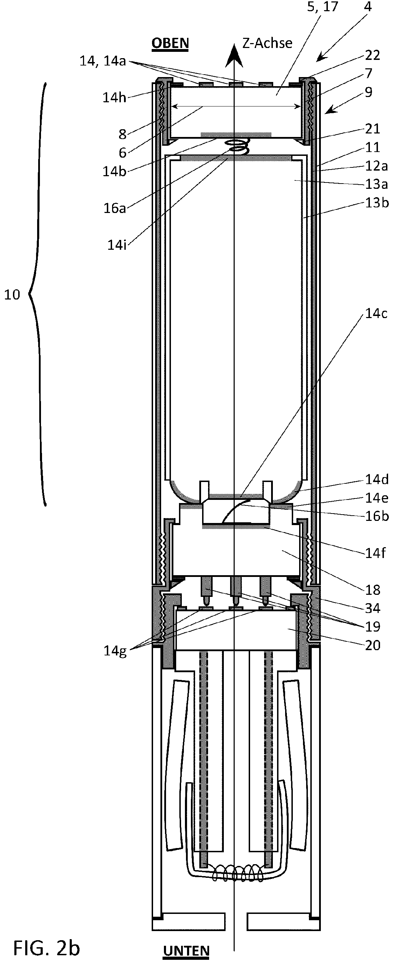

Die Fig. 2a, 2b zeigen eine Ausführungsform der erfindungsgemässen Ladespitze 4, bei welcher im Vergleich zur oben beschriebenen Ausführungsform der Steuerelementkörper 5 im Verschlusselement 7 mittels Passsitz positioniert ist und zudem mit einem Pressring 21 am unteren Ende des Steuerelementkörpers 5 fixiert ist. Dabei weist der Steuerelementkörper 5 zwar keinen Mantelflächenkontakt 15 wie in Fig. 1b auf, aber dafür eine weitere elektrische Kontaktfläche 14h, die mit dem leitfähigen Verschlusselement 7 elektrisch verbunden ist und in der Folge über die Verbindungsstruktur 8 mit der Innerröhre 12a der Batteriehülse 9, dem Verschlussbauteil 34, der Steuereinheit 18 und der Patroneneinheit 20. Auch bei dieser Ausführungsform dienen die aufgezeigten elektrischen Verbindungen beispielsweise der Ladung der Batterie 13a oder einem Datenaustausch von und zu dem Steuerelementkörper 5, der Steuereinheit 18 bzw. der Patronensteuerung 20. Ein solcher Datenaustausch kann dabei -wie bereits oben erwähnt- zum Beispiel Schaltbefehle mitumfassen, sowie Parametrierdaten oder Programmierdaten, wobei der Steuerelementkörper 5 auch hier als Leitplattenstruktur 17, auf die später einzugehen sein wird, ausgebildet ist.

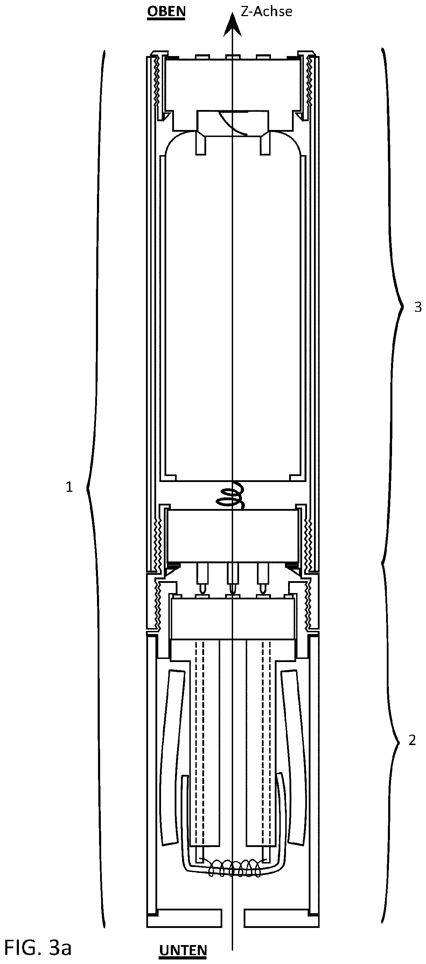

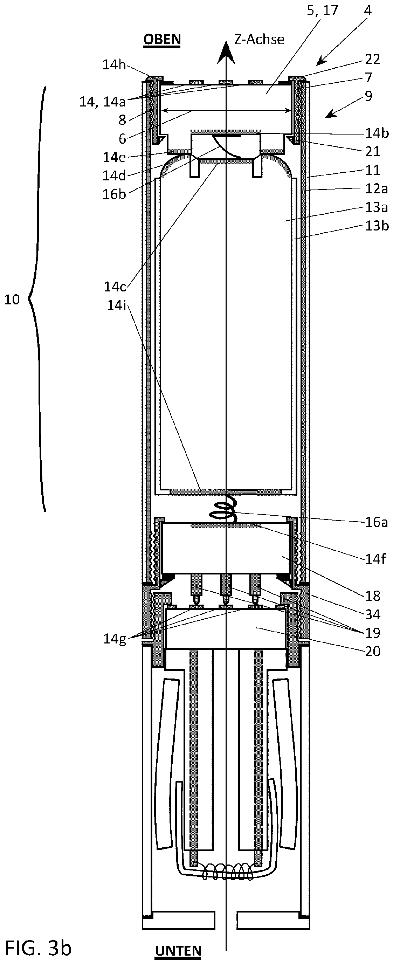

Bei der erfindungsgemässen Ausführungsform der Ladespitze 4 in den Fig. 3a, 3b steht der Steuerelementkörper 5 dieser Ladespitze 4 unmittelbar mit zwei Kontaktflächen 14c und 14d mit der Batterie 13a in leitender Verbindung, da -wie gezeigt- diese Batterie 13a gegenüber den vorhergehenden Ausführungsformen um 180° gedreht ist und somit die beiden elektrischen Kontaktflächen 14c, 14d hier nach oben zeigen, wobei der Federkontakt 16b die elektrischen Kontaktflächen 14b des Steuerelementkörpers 5 und 14c der Batterie miteinander verbindet. Der Ausführungsform in den Fig. 2a, 2b ähnlich, ist der Steuerelementkörper 5 auch hier mittels eines Passsitzes in dem Versschlusselement 7 positioniert und mit dem Pressring 21 fixiert und am unteren Ende der Batterie 13a stellt der Federkontakt 16a die Verbindung zur Steuereinheit 18 her. In nun bereits bekannter Weise bestehen auch hier mit der Innenröhre 12a elektrische Wirkverbindungen ausgehend vom Steuerelementkörper 5 über das Verschlussbauteil 34 bis zur Steuereinheit 18 und der Patronensteuerung 20.

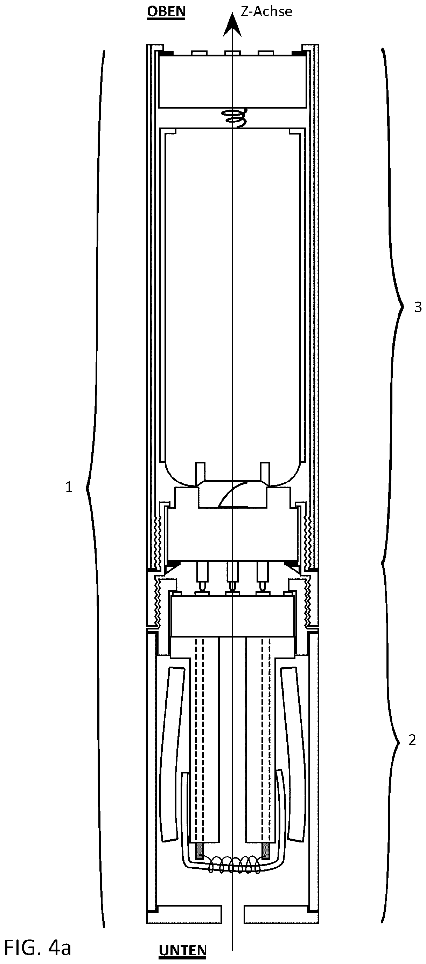

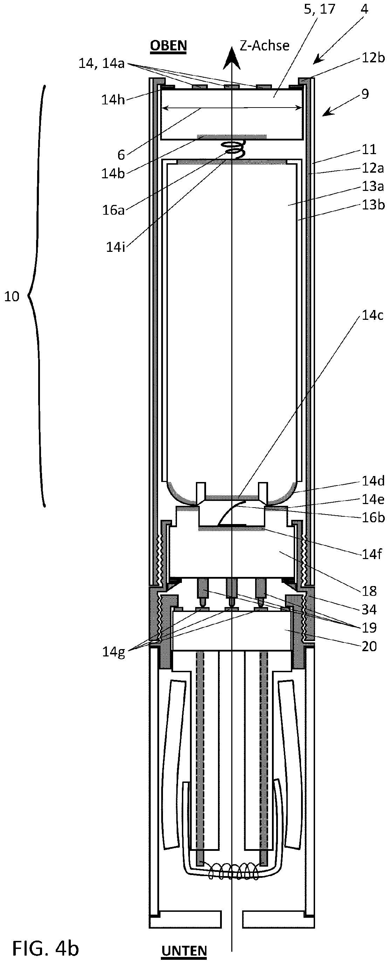

Als ein wesentlicher Unterschied zu den Ausführungsformen in den Fig. 1a bis 2b zeigt die weitere Ausführungsform der erfindungsgemässen Ladespitze 4 in den Fig. 4a, 4b einen Steuerelementkörper 5, der -ohne Verschlusselement 7- unmittelbar einen Passsitz mit der Innenröhre 12a der Batteriehülse 9 eingeht, wobei diese Innenröhre 12a zwecks Positionierung am oberen Ende einen Flansch 12b aufweist, gegen den der Steuerelementkörper 5 mit elektrischen Kontaktflächen 14h angeordnet ist. Der Federkontakt 16a drückt den Steuerelementkörper 5 ausgehend vor der elektrische Kontaktfläche 14i der Batterie gegen die elektrische Kontaktfläche 14b und folglich gegen den Flansch 12b der Innenröhre 12a. Auch hier stellt die Innenröhre 12a die elektrische Verbindung zwischen dem Steuerelementkörper 5, dem Verschlussbauteil 34 und der Steuereinheit 18 bzw. der Patroneneinheit 20 bereit, deren Bedeutung bereits oben hinreichend beschrieben wurden.

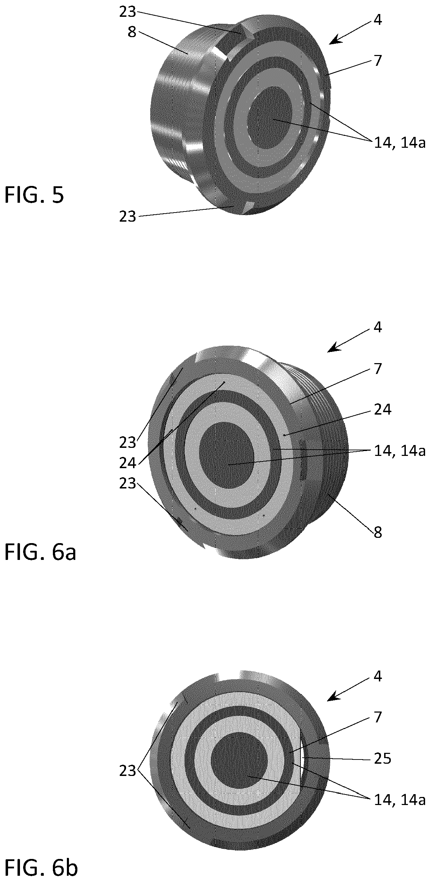

Fig. 5 zeigt in einer perspektivischen Darstellung die erfindungsgemässe Ladespitze 4 in einer schrägen Draufsicht auf die elektrischen Kontaktflächen 14, 14a. Das Verschlusselement 7 weist hier neben der Verbindungsstruktur 8 Ausnehmungen 23 auf, die für den Eingriff eines hier nicht gezeigten Werkzeugs zwecks Montage bzw. Demontage der Ladespitze 4 dienlich sind. Ferner sind bei weiteren Ausführungsformen der erfindungsgemässen Ladespitze 4 Bohrungen 24, siehe Fig. 6a, oder eine Abflachungen 25, siehe Fig. 6b vorgesehen, welche mit nicht näher spezifizierten Einwegventilen ausgestattet sind, durch die zwar jedenfalls Luft/Gas austreten kann, aber niemals Luft/Gas in die elektrische Zigarette eindringen kann. Der Hintergrund für die Bohrungen 24 bzw. die Abflachung 25 mit Einwegventilfunktion ist darin zu sehen, dass bei einem Batteriefehler giftige Stoffe aus der Batterie austreten können, die keinesfalls eingeatmet werden sollten. Somit haben die Bohrungen 24 bzw. die Abflachung 25 eine besondere Schutzfunktion bei einem Batteriefehler.

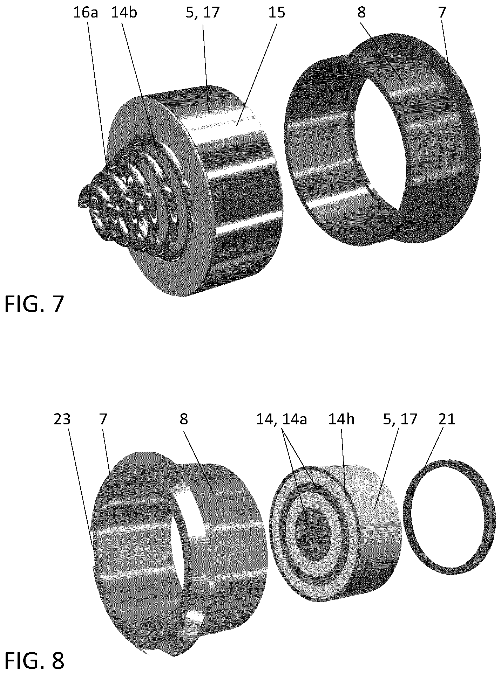

Fig. 7 zeigt in einer perspektivischen, teilweise explosionsartigen Darstellung den Steuerelementkörper 5 mit dem Mantelflächenkontakt 15, der -wie zu den Fig. 1a, 1b bereits erläutert, mit dem Verschlusselement 7 eine elektrische Verbindung eingeht. Um diese elektrische Verbindung unterbruchsfrei gewährleisten zu können, ist vorliegend der Passsitz zwischen dem Steuerelementkörper 5 und dem Verschlusselement 7 vorzugsweise als eine Übergangspassung ausgebildet, so dass der Steuerelementkörper 5 hierdurch positioniert und derart fixiert ist, dass er lediglich mit geringem Druck noch verschiebbar ist.

In Fig. 8 ist eine perspektivische, teilweise explosionsartigen Darstellung des Steuerelementkörper 5 gezeigt, welcher mittels eines Pressrings 21 im Verschlusselement 7 fixierbar ist. In dieser Ausführungsform der erfindungsgemässen Ladespitze kann der Passsitz des Steuerelementkörpers 5 in dem Verschlusselement 7 als eine Spielpassung ausgebildet sein, wobei hierbei der Steuerelementkörper 5 leicht verschiebbar im Verschlusselement 7 positionierbar ist und mit dem Pressring 7 darin fixierbar ist; Beispiele für eine solche Anordnung finden sich in den oben erläuterten Fig. 2a bis 3b, wobei die elektrische Verbindung zum Verschlusselement 7 hier durch die elektrische Kontaktfläche 14h des Steuerelementkörpers 5 bereitstellbar ist.

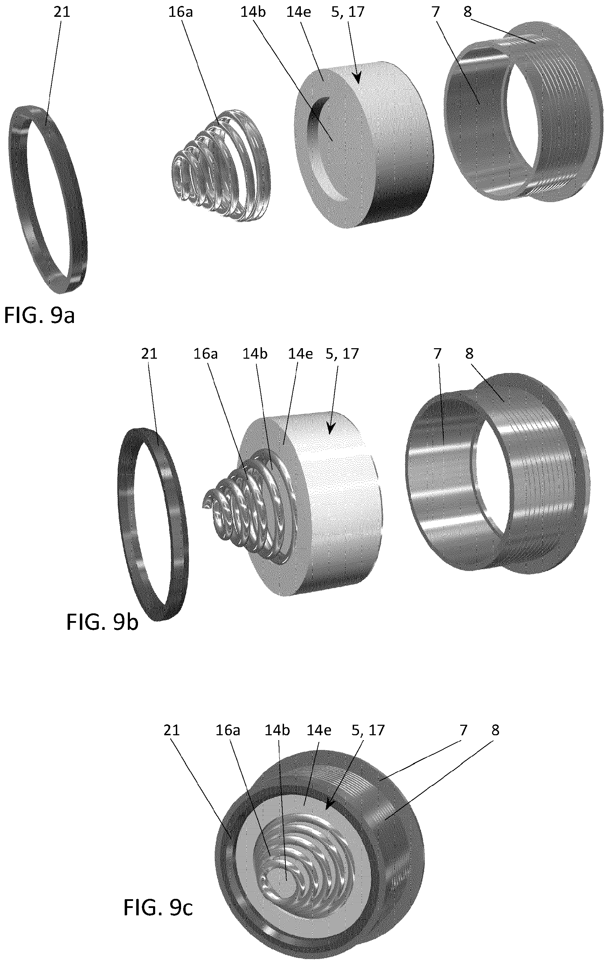

Die Fig. 9a - 9c zeigen die Ausführungsform der Ladespitze gemäss der Fig. 3a, 3b in ebenfalls perspektivischer, teilweise explosionsartigen Darstellung mit den beiden elektrischen Kontaktflächen 14b, 14e am Steuerelementkörper 5, die mit der Batterie 13a eine Verbindung eingehen, siehe auch Fig. 3b hierzu.

Wie bereits oben mehrfach angesprochen, ist der Steuerelementkörper 5 der erfindungsgemässen Ladespitze 4 als eine Leiterplattenstruktur 17 ausgebildet, wie in Fig. 10 gezeigt. Diese Leiterplattenstruktur 17 kann eine oder mehrere der nachfolgend gelisteten Funktionen der elektrischen Zigarette aufweisen, namentlich eine Luftmengenmessung, eine Restmengenbestimmung für eine Aerosolvorläuferverbindung, eine Ladezustandsbestimmung der Batterie, eine Authentifizierungsvorrichtung oder eine Kommunikationseinrichtung (RFID, Bluetooth,...), gegebenenfalls für einen Datenaustausch mit einem Smartphone oder einer Smartwatch, wobei diese Funktionsliste als nicht abgeschlossen zu betrachten ist.

Fig. 10 zeigt nun eine beispielhafte Ausführungsform der Leiterplattenstruktur 17, mit den elektrischen Kontaktflächen 14h, 14, 14a, an der Oberseite bzw. 14b an der Unterseite derselben; eine solche Anordnung der elektrischen Kontakte eignet sich beispielsweise für den Einsatz in elektrische Zigaretten gemäss der Fig. 3a, 3b. Die in Fig. 10 dargestellte Leiterplattenstruktur 17 umfasst eine Anzahl von Leiterbahnen bzw. Durchkontaktierungen 27 und eine Anzahl integrierter Strukturen wie beispielsweise eine Authentifizierungseinheit 26, ein Schaltelement 28, einen Sensor 30, einen Mikrokontroller 29 und ein elektronisches Bauelement 31, welche auf mittels Isolationsfüllungen 32 voneinander isoliert ausgebildeten Leiterplatten 33 angeordnet sind. Mittels einer solchen Leiterplattenstruktur 17 sind eine Vielzahl von Funktionen der elektrischen Zigarette abbildbar, wobei gegebenenfalls weitere Strukturen ergänzt werden können oder weggelassen werden können. Ohne den Erfindungsgedanken zu verlassen ist es auch denkbar, dass weitere Funktionen in der Leiterplattenstruktur 17 integriert werden, die hier nicht explizit genannt sind.

Vorliegend offenbart Fig. 10 in einer stark vergrösserten Schnittdarstellung eine mögliche Ausführungsform für die Leiterplattenstruktur 17 der elektrischen Zigarette 1. In ihrer einfachsten Form umfasst diese Leiterplattenstruktur 17 mindestens eine Leiterplatte 33, die mit einem Sensor 30 und/oder einem oder mehreren elektrischen Bauelementen 31 und/oder einem Mikrocontroller 29 ausgestattet ist. Es ist hier ein beispielhafter Aufbau auf Basis eingebetteter elektronischer Bauelemente dargestellt. Die später innenliegenden Bauteile 29, 30, 31 werden in dieser hier dargestellten Einbett-Technologievariante mittels eines Lötverfahrens auf die jeweilige, z.B. durch Ätzen strukturierte Kupferlage aufgelötet und im weiteren Leiterplatten-Fertigungsprozess durch Decklagen aus einer Isolationsfüllung bzw. aus Leiterplattenmaterial 32 (Prepregs) abgedeckt. Die Kupferlagen, auf die die Bauteile gelötet werden, können entweder einzelne Folien oder wie im dargestellten Fall Bestandteil von vorbereiteten Zwei- oder MehrlagenLeiterplatten, bestehend aus mindestens einem Isolator, z.B. aus einem gehärteten Prepreg 32 und zwei aufgepressten Kupferlagen, sein. Abhängig von der Konstruktion und der Materialwahl wird z.B. das Harz in den Decklagen-Materialien während des nachfolgenden Leiterplatten-Pressprozesses zur Verfüllung von Freiräumen im Umfeld der eingebetteten Bauelemente genutzt.

Es sind weitere Einbett-Technologien verfügbar, die auch die Verarbeitung von nichtgehäusten aktiven elektronischen Komponenten, wie z.B. Mikrocontroller oder ASICs, ohne einen extra Lötprozess ermöglichen. Bei diesen Technologien werden für die Bauteilkontaktierung der später innenliegenden elektronischen Bauteile Standardverfahren aus der Leiterplattenindustrie, z.B. Mikrobohrungen (HDI-Technologie, Microvias) und Galvanik, genutzt. Der grundsätzliche Aufbau mit eingebetteten Bauelementen bleibt aber unabhängig von der gewählten Embedded-Variante weitgehend gleich. Auch mit den 3D-Druck-/Additivverfahren, z.B. auf Pasten-/Lackbasis mit Trocknung bzw. Aushärtung mit UV-Licht, lassen sich Mehrlagenleiterplatten mit eingebetteten Bauelementen herstellen.

Neben der Einbettung elektronischer Bauteile ermöglicht die Nutzung der Grossserien-tauglichen Leiterplattentechnologie auch eine komplexe 3D-Strukturierung der entstehenden Baugruppe mit Standard-bearbeitungsverfahren bei gleichzeitig hoher Genauigkeit bzw. mit geringen Toleranzen. Dabei sind mechanische Führungen und zusätzliche äussere Kontaktelemente sehr leicht in abschliessenden Leiterplattenprozessen realisierbar.

Die verschiedenen Ebenen der Mehrlagenleiterplatte mit eingebetteten elektronischen Bauteilen werden mittels Durchkontaktierungen 27 (Microvias, Vias) in einem Leiterplatten-Standardprozess miteinander verbunden und sichern die elektrischen Verbindungen in der Z-Achse der kompakten Baugruppe.

Eine derart ausgebildete Leiterplattenstruktur für die Ladespitze zeichnet sich gegenüber dem Stand der Technik neben der verbesserten Miniaturisierung auch durch kleineren Energieverbrauch und geringer Verlustleistung aus. Vorliegend umfasst die Leiterplattenstruktur 17 mehrere voneinander isoliert angeordnete Leiterplatten 33 mit eingebetteten Elementen, wie dem Mikrocontroller 29, dem Sensor 30 und dem elektrischen Bauelement 31, welche hier lediglich als Beispiele für weitere äquivalent ausgestattete Ausführungsformen stehen sollen; typischerweise sind die hier horizontal und somit senkrecht zur Z-Achse angeordneten Leiterplatten 33 von Isolationsfüllungen 2 beabstandet, wobei Leiterbahnen bzw. Durchkontaktierungen 27 teilweise oder vollständig die Leiterplattenstruktur 17 elektrisch verbinden.

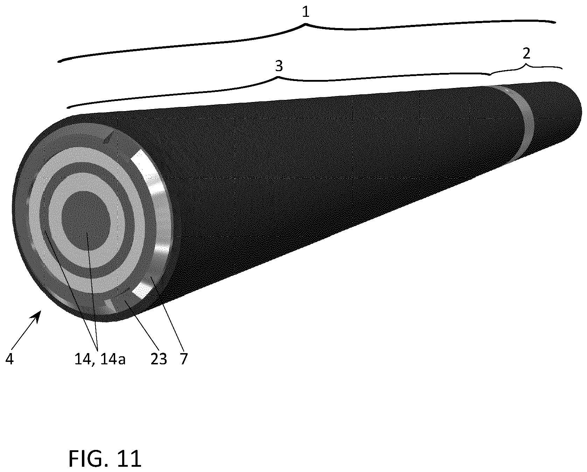

Fig. 11 zeigt abschliessend in einer perspektivischer Darstellung eine elektrische Zigarette 1, die mittels der hier in Rede stehenden, erfindungsgemässen Ladespitze 4 einseitig verschlossen ist; erkennbar sind die aussen angeordneten, elektrischen Kontaktflächen 14, 14a, die mit einem hier nicht näher erläuterten bzw. gezeigten Ladegerät verbindbar sind.

### Bezugszeichenliste

- 1: elektrische Zigarette
- 2: Patroneneinheit
- 3: Kontrolleinheit
- 4: Ladespitze
- 5: Steuerelementkörper
- 6: Körperdurchmesser
- 7: Verschlusselement
- 8: Verbindungsstruktur (Gewinde, Bajonette, Einrastung)
- 9: Batteriehülse
- 10: Batterieeinheit
- 11: Aussenröhre der 9, elektrisch nichtleitend
- 12a: Innenröhre der 9, elektrisch leitend
- 12b: Flansch an 12a
- 13a: Batterie
- 13b: Batterieisolierung
- 14, 14a, 14b, 14c,: elektrische Kontaktfläche
- 14d, 14e, 14f, 14g, 14h, 14i 15: Mantelflächenkontakt
- 16a, 16b: Federkontakt
- 17: Leiterplattenstruktur mit Intelligenz (Authentifizierung, RFID, Durchflussmenge)
- 18: Steuereinheit
- 19: Kontaktstift
- 20: Patronensteuerung
- 21: Pressring
- 22: Flanschabschluss an 7
- 23: Ausnehmung in 7 für Werkzeugeingriff
- 24: Bohrung
- 25: Abflachung, entferntes Kreissegment bzw. Kreisabschnitt
- 26: Authentifizierungseinheit
- 27: Durchkontaktierung
- 28: Schaltelement
- 29: Mikrocontroller
- 30: Sensor
- 31: elektronisches Bauelement
- 32: Isolationsfüllung
- 33: Leiterplatte
- 34: Verschlussbauteil

## Patentansprüche

1. Eine Ladespitze (4) für eine elektrische Zigarette (1), welche entlang einer zentralen Z-Achse von unten nach oben eine Patroneneinheit (2) und eine daran lösbar angeordnete Kontrolleinheit (3) aufweist, wobei an einem der Patroneneinheit (2) abgewandten Ende der elektrischen Zigarette (1) diese Ladespitze (4) anordenbar ist und wobei diese Ladespitze (4) eine Anzahl elektrischer Kontaktflächen (14) aufweist, die zwecks einer Aufladung der elektrischen Zigarette (1) und/oder zwecks eines Datenaustauschs mit der elektrischen Zigarette (1) kontaktierbar sind,
wobei die Ladespitze (4) einen Steuerelementkörper (5) mit einem Körperdurchmesser (6) senkrecht zur zentralen Z-Achse umfasst, wobei dieser Körperdurchmesser derart gewählt ist, dass der Steuerelementkörper (5) mit der elektrischen Zigarette (1) einen Passsitz ausbilden kann, **dadurch gekennzeichnet, dass** der Steuerelementkörper (5) als eine Leiterplattenstruktur (17) ausgebildet ist und dass die Leiterplattenstruktur (17) mindestens eine mittels einer Isolationsfüllung (32) isolierte Leiterplatte (33) umfasst, wobei diese mindestens eine Leiterplatte (33) quer zur Z-Achse ausgerichtet werden kann.

2. Ladespitze (4) gemäss Anspruch 1, **dadurch gekennzeichnet, dass** der Steuerelementkörper (5) lösbar in einem Verschlusselement (7) oder in einer Batteriehülse (9) an der Ladespitze (4) der elektrischen Zigarette (1) den Passsitz ausbilden kann und mit dem Verschlusselement (7) bzw. der Batteriehülse (9) elektrisch wirkverbindbar ist.

3. Ladespitze (4) gemäss einem der Ansprüche 1 oder 2, **dadurch gekennzeichnet, dass** der Steuerelementkörper (5) lösbar an der Ladespitze (4) der elektrischen Zigarette (1) mittels des Passsitzes positionierbar ist und mit einem Pressring (21) fixierbar ist.

4. Ladespitze (4) gemäss Anspruch 3, **dadurch gekennzeichnet, dass** die mindestens eine Leiterplatte (33) mindestens einen Sensor (30) und/oder mindestens einen Mikrocontroller (29) und/oder mindestens ein elektronisches Bauelement (31) aufweist, welche elektrisch auf dieser mindestens einen Leiterplatte (33) und/oder mittels einer Leiterbahn und/oder mittels einer Durchkontaktierung (27) mit der Anzahl elektrischer Kontakte (14, 14a - 14i), oder mit einem Mantelflächenkontakt (15) in elektrischer Wirkverbindung stehen.

5. Ladespitze (4) gemäss Anspruch 4, **dadurch gekennzeichnet, dass** der mindestens eine Sensor (30) und/oder der mindestens eine Mikrocontroller (29) und/oder das mindestens eine elektronische Bauelement (31) mit der mindestens einen Leiterplatte (33) als in die Leiterplattenstruktur (17) eingebettete, integrierte elektronische Komponenten ausgebildet sind.

6. Ladespitze (4) gemäss einem der Ansprüche 1 bis 5, **dadurch gekennzeichnet, dass** die Leiterplattenstruktur (17) eine Authentifizierungsvorrichtung (26) umfasst.

7. Ladespitze (4) gemäss einem der Ansprüche 1 bis 6, **dadurch gekennzeichnet, dass** die Leiterplattenstruktur (17) ein Schaltelement (28) umfasst.

8. Ladespitze (4) gemäss einem der Ansprüche 1 bis 7, **dadurch gekennzeichnet, dass** der Steuerelementkörper (5) eine Abflachung (25) oder eine Bohrung (24) aufweist.

9. Ladespitze (4) gemäss einem der Ansprüche 1 bis 8, **dadurch gekennzeichnet, dass** der mit der elektrischen Zigarette (1) ausbildbare Passsitz des Steuerelementkörpers (5) als eine Spielpassung ausgebildet werden kann, wobei der Steuerelementkörper (5) gerade noch leicht verschiebbar angeordnet ist.

10. Ladespitze (4) gemäss einem der Ansprüche 1 bis 8, **dadurch gekennzeichnet, dass** der mit der elektrischen Zigarette (1) ausbildbare Passsitz des Steuerelementkörpers (5) als eine Übergangspassung ausgebildet werden kann, wobei der Steuerelementkörper (5) mit geringem Druck verschiebbar angeordnet ist.

## Claims

1. A charging tip (4) for an electric cigarette (1), which has a cartridge unit (2) and a control unit (3) detachably arranged thereon along a central Z-axis from bottom to top, wherein this charging tip (4) can be arranged at an end of the electric cigarette (1) facing away from the cartridge unit (2) and wherein this charging tip (4) has a number of electrical contact surfaces (14) which can be contacted for the purpose of charging the electric cigarette (1) and/or for the purpose of exchanging data with the electric cigarette (1), wherein the charging tip (4) comprises a control element body (5) with a body diameter (6) perpendicular to the central Z-axis, this body diameter being selected such that the control element body (5) can form a tight fit with the electronic cigarette (1), **characterized in that** the control element body (5) is designed as a printed circuit board structure (17) and that the printed circuit board structure (17) comprises at least one printed circuit board (33) insulated by means of an insulating filling (32), wherein this at least one printed circuit board (33) can be aligned transversely to the Z-axis.

2. Charging tip (4) according to claim 1, **characterized in that** the control element body (5) can detachably form the fit in a closure element (7) or in a battery sleeve (9) on the charging tip (4) of the electric cigarette (1) and can be electrically operatively connected to the closure element (7) or the battery sleeve (9).

3. Charging tip (4) according to one of claims 1 or 2, **characterized in that** the control element body (5) can be detachably positioned on the charging tip (4) of the electronic cigarette (1) by means of the fit and can be fixed with a press ring (21).

4. Charging tip (4) according to claim 3, **characterized in that** the at least one printed circuit board (33) has at least one sensor (30) and/or at least one microcontroller (29) and/or at least one electronic component (31), which are electrically operatively connected to the number of electrical contacts (14, 14a - 14i) on this at least one printed circuit board (33) and/or by means of a conductor track and/or by means of a through-plating (27), or to a surface contact (15).

5. Charging tip (4) according to claim 4, **characterized in that** the at least one sensor (30) and/or the at least one microcontroller (29) and/or the at least one electronic component (31) with the at least one printed circuit board (33) are designed as integrated electronic components embedded in the printed circuit board structure (17).

6. Charging tip (4) according to one of claims 1 to 5, **characterized in that** the printed circuit board structure (17) comprises an authentication device (26).

7. Charging tip (4) according to any one of claims 1 to 6, **characterized in that** the circuit board structure (17) comprises a switching element (28).

8. Charging tip (4) according to any one of claims 1 to 7, **characterized in that** the control element body (5) comprises a flattening (25) or a bore (24).

9. Charging tip (4) according to one of claims 1 to 8, **characterized in that** the fit of the control element body (5), which can be formed with the electric cigarette (1), can be designed as a clearance fit, the control element body (5) being arranged so as to be just slightly displaceable.

10. Charging tip (4) according to one of claims 1 to 8, **characterized in that** the fit of the control element body (5) which can be formed with the electric cigarette (1) can be designed as a transition fit, the control element body (5) being arranged so as to be displaceable with slight pressure.

## Revendications

1. Une pointe de charge (4) pour une cigarette électrique (1), qui comprend le long d'un axe central Z de bas en haut une unité de cartouche (2) et une unité de contrôle (3) disposée de manière amovible sur celle-ci, cette pointe de charge (4) pouvant être disposée à une extrémité de l'e-cigarette (1) opposée à l'unité de cartouche (2) et cette pointe de charge (4) présentant un certain nombre de surfaces de contact électriques (14) qui peuvent être contactées en vue d'une charge de l'e-cigarette (1) et/ou en vue d'un échange de données avec l'e-cigarette (1), la pointe de charge (4) comprenant un corps d'élément de commande (5) avec un diamètre de corps (6) perpendiculaire à l'axe central Z, ce diamètre de corps étant choisi de telle sorte que le corps d'élément de commande (5) puisse former un ajustement serré avec la cigarette électrique (1), **caractérisé en ce que** le corps d'élément de commande (5) est conçu de telle sorte que le corps d'élément de commande (5) puisse former un ajustement serré avec la cigarette électrique (1), **en ce que** le corps d'élément de commande (5) est conçu comme une structure de carte de circuit imprimé (17) et **en ce que** la structure de carte de circuit imprimé (17) comprend au moins une carte de circuit imprimé (33) isolée au moyen d'un remplissage isolant (32), cette au moins une carte de circuit imprimé (33) pouvant être orientée transversalement à l'axe Z.

2. Pointe de charge (4) selon la revendication 1, **caractérisée en ce que** le corps de l'élément de commande (5) peut former le siège d'ajustage de manière amovible dans un élément de fermeture (7) ou dans une douille de batterie (9) sur la pointe de charge (4) de la cigarette électrique (1) et peut être relié activement électriquement à l'élément de fermeture (7) ou à la douille de batterie (9).

3. Pointe de charge (4) selon l'une des revendications 1 ou 2, **caractérisée en ce que** le corps de l'élément de commande (5) peut être positionné de manière amovible sur la pointe de charge (4) de l'e-cigarette (1) au moyen du siège d'ajustement et peut être fixé avec une bague de pression (21).

4. Pointe de charge (4) selon la revendication 3, **caractérisée en ce que** la au moins une carte de circuit imprimé (33) présente au moins un capteur (30) et/ou au moins un microcontrôleur (29) et/ou au moins un composant électronique (31) qui sont en liaison électrique active sur cette au moins une carte de circuit imprimé (33) et/ou au moyen d'une piste conductrice et/ou au moyen d'un contact traversant (27) avec le nombre de contacts électriques (14, 14a - 14i), ou avec un contact de surface d'enveloppe (15).

5. Pointe de charge (4) selon la revendication 4, **caractérisée en ce que** l'au moins un capteur (30) et/ou l'au moins un microcontrôleur (29) et/ou l'au moins un composant électronique (31) avec l'au moins une carte de circuit imprimé (33) sont conçus comme des composants électroniques intégrés, noyés dans la structure de carte de circuit imprimé (17).

6. Pointe de charge (4) selon l'une des revendications 1 à 5, **caractérisée en ce que** la structure de carte de circuit imprimé (17) comprend un dispositif d'authentification (26).

7. Pointe de charge (4) selon l'une des revendications 1 à 6, **caractérisée en ce que** la structure de circuit imprimé (17) comprend un élément de commutation (28).

8. Pointe de charge (4) selon l'une des revendications 1 à 7, **caractérisée en ce que** le corps de l'élément de commande (5) présente un méplat (25) ou un alésage (24).

9. Pointe de charge (4) selon l'une des revendications 1 à 8, **caractérisée en ce que** l'ajustement du corps de l'élément de commande (5) pouvant être formé avec la cigarette électrique (1) peut être réalisé sous la forme d'un ajustement avec jeu, le corps de l'élément de commande (5) étant disposé de manière à pouvoir tout juste encore légèrement coulisser.

10. Pointe de charge (4) selon l'une des revendications 1 à 8, **caractérisée en ce que** le siège d'ajustement du corps d'élément de commande (5) pouvant être formé avec la cigarette électrique (1) peut être formé comme un ajustement de transition, le corps d'élément de commande (5) étant disposé de manière à pouvoir être déplacé avec une faible pression.
